# EUROPÄISCHE PATENTSCHRIFT

(11) **EP 3 877 770 B1**
(45) Veröffentlichungstag und Bekanntmachung des Hinweises auf die Patenterteilung: **25.10.2023**
(21) Anmeldenummer: 19831620.0
(22) Anmeldetag: 12.12.2019
(51) Int. Cl.: H05B 45/14, H05B 45/345, G01R 19/00

(54) **STROMSENSOR UND MESSVERFAHREN ZUR GESCHALTETEN ERFASSUNG EINES WECHSELSTROMS**
CURRENT SENSOR AND MEASURING METHOD FOR THE SWITCHED SENSING OF AN ALTERNATING CURRENT
CAPTEUR DE COURANT ET PROCÉDÉ DE MESURE POUR LA DÉTECTION COMMUTÉE D'UN COURANT ALTERNATIF

(30) Priorität: 18.12.2018 DE 102018132656
(43) Veröffentlichungstag der Anmeldung: 15.09.2021
(73) Patentinhaber: Tridonic GmbH & Co. KG, 6851 Dornbirn (AT)
(72) Erfinder: KLIEN, Dietmar, 6841 Mäder (AT)
(74) Vertreter: Rupp, Christian
(86) Internationale Anmeldenummer: PCT/EP2019/084975
(87) Internationale Veröffentlichungsnummer: WO 2020/126858

(56) Entgegenhaltungen:
- WO-A2-2014/060899
- DE-A1-102014 215 835
- US-A1- 2006 132 062
- US-A1- 2014 268 951

## Beschreibung

Die Erfindung betrifft einen Stromsensor und ein Verfahren zur Erfassung eines Wechselstroms, insbesondere zur Erfassung eines sekundärseitigen Wechselstroms in einem vorzugsweise isolierten DC-DC-Konverter (Gleichspannungswandler).

Wird ein resonanter Konverter, insbesondere ein DC-DC-Konverter mit Pulsweitenmodulation (PWM) betrieben, wird häufig der mittlere Strom durch einen angeschlossenen Verbraucher, insbesondere eine oder mehrere LEDs, über einen Stromwandler mit Gleichrichter erfasst. Durch die Diodenkapazität des Leistungs-Gleichrichters im DC-DC-Konverter entsteht dabei ein Messfehler. Während der Ausschalt-Phase der Halbbrücke des DC-DC-Konverters schwingt der Resonanzkreis aus und es fließt über die Diodenkapazitäten ein Wechselstrom, welcher nicht zum LED-Strom beiträgt, weil sein Mittelwert 0 ist. Dieser Wechselstrom wird jedoch durch den Gleichrichter auf der Sekundärseite des Stromwandlers mitgemessen.

Dies führt zu einer ungenauen Messung des Stroms, was wiederum zu einer ungenauen Regelung des DC-DC-Konverters führt.

Ein herkömmlicher Konverter geht zum Beispiel aus dem Dokument WO 2016/016044 hervor.

Weitere, für den Stand der Technik relevante Dokumente sind: US 2006/132062 A1, WO 2014/060899 A2, DE 10 2014 215835 A1 und US 2014/268951 A1.

Der Erfindung liegt die Aufgabe zugrunde, einen Stromsensor und ein Messverfahren zur Erfassung eines Wechselstroms bereitzustellen, welche unabhängig von einer Betriebsart des Konverters eine hohe Messgenauigkeit erreicht, ohne dabei eine aufwendige Hardware zu erfordern.

Die Aufgabe wird erfindungsgemäß für die Vorrichtung durch die Merkmale des unabhängigen Anspruchs 1 und für das Verfahren durch die Merkmale des unabhängigen Anspruchs 12 gelöst. Vorteilhafte Weiterbildungen sind Gegenstand der hierauf rückbezogenen Unteransprüche.

Ein erfindungsgemäßer Stromsensor dient der Erfassung eines Wechselstroms. Der Stromsensor weist einen Koppler auf, welcher ausgebildet ist, um einen proportionalen Teil des Wechselstroms als Messstrom auszukoppeln. Darüber hinaus weist der Stromsensor einen Schaltanschluss auf, welcher zur Einspeisung eines Schaltsignals ausgebildet ist. Darüber hinaus beinhaltet der Stromsensor einen schaltbaren Gleichrichter, welcher ausgebildet ist, um den Messstrom gesteuert von dem Schaltsignal gleichzurichten, und als gleichgerichteten Messstrom auszugeben. Die Schaltbarkeit des Gleichrichters mittels des Schaltsignals ermöglicht ein Deaktivieren des Gleichrichters in Zeiten, in welchen lediglich ein Fehlerstrom entstehen würde.

Der schaltbare Gleichrichter weist eine Schalteinrichtung auf, welche ausgebildet ist, um gesteuert durch das Schaltsignal die Gleichrichtung durch den schaltbaren Gleichrichter einzuschalten und auszuschalten. Dadurch wird eine besonders einfache Implementierung des Stromsensors gewährleistet.

Vorzugsweise ist die Schalteinrichung derart realisiert, dass die masseseitigen Gleichrichtelemente eines Brückengleichrichters durch aktive Schaltelemente mit vorzugsweise integrierter Freilaufdiode wie beispielsweise Transistoren, insbesondere MOSFET ersetzt werden. Wenn diese beiden unteren Gleichrichtelemente angesteuert werden, kann dies ohne aufwendige "high side" Ansteuerung erfolgen. Darüber hinaus kann durch Nutzung der integrierten Freilaufdiode auf eine externe Freilaufdiode verzichtet werden.

Die aktiven Schaltelemente werden vorzugsweise durch Transistoren wie beispielsweise MOSFET oder GaN-FET gebildet werden.

Vorzugsweise weist die Schalteinrichtung dabei zumindest zwei Transistoren auf, welche ausgebildet sind, um gesteuert durch das Schaltsignal die Gleichrichtung durch den schaltbaren Gleichrichter einzuschalten und auszuschalten. Dies ermöglicht eine besonders einfache Implementierung der Schalteinrichtung.

Vorzugsweise weist der schaltbare Gleichrichter einen ersten Transistor, eine erste Diode, einen zweiten Transistor und eine zweite Diode auf. An einem ersten Knoten sind der erste Transistor und der zweite Transistor eingangsseitig parallel geschaltet. An einem zweiten Knoten ist die erste Diode in Serie zu dem ersten Transistor geschaltet. An einem dritten Knoten ist die zweite Diode in Serie zu dem zweiten Transistor geschaltet. An einem vierten Knoten sind die erste Diode und die zweite Diode ausgangsseitig parallel geschaltet. Eine besonders einfache Implementierung des geschalteten Gleichrichters wird dadurch erreicht.

Vorzugsweise ist der geschaltete Gleichrichter ausgebildet, um den Messstrom an dem zweiten Knoten und dem dritten Knoten zu empfangen, und den gleichgerichteten Messstrom an dem ersten Knoten und dem vierten Knoten auszugeben. So wird eine einfache Implementierung des geschalteten Gleichrichters erreicht.

Ein erfindungsgemäßer Konverter weist eine primärseitige Konverter-Einrichtung, einen Koppler, eine sekundärseitige Konverter-Einrichtung und einen zuvor beschriebenen Stromsensor auf. So wird eine besonders einfache Konstruktion des Konverters erreicht.

Vorzugsweise basiert das Schaltsignal dabei auf Schaltzeiten der primärseitigen Konverter-Einrichtung. So wird eine besonders einfache Implementierung des Schaltsignals erzielt.

Bevorzugterweise beinhaltet der Konverter weiterhin einen Schaltsignal-Generator, welcher ausgebildet ist, um das Schaltsignal basierend auf Schaltzeiten der primärseitigen Konverter-Einrichtung zu erzeugen. Eine besonders einfache Erzeugung des Schaltsignals wird dadurch gewährleistet.

Bevorzugt ist der Schaltsignal-Generator ausgebildet, um das Schaltsignal als Inverses der Schaltvorgänge einer Halbbrücke der primärseitigen Konverter-Einrichtung zu erzeugen. Eine besonders einfache Erzeugung des Schaltsignals wird so erreicht.

Vorzugsweise ist der schaltbare Gleichrichter dabei ausgebildet, um den Messstrom während einer Einschaltphase der Halbbrücke der primärseitigen Konverter-Einrichtung gleichzurichten, und den Messstrom während einer Ausschaltphase der Halbbrücke der primärseitigen Konverter-Einrichtung kurzuschließen, also auch nicht gleichzurichten. So wird sichergestellt, dass Fehlerströme während der Ausschaltphase der Halbbrücke nicht erfasst werden.

Vorzugsweise ist die primärseitige Konverter-Einrichtung ausgebildet, um basierend auf dem gleichgerichteten Messstrom zu arbeiten. Die sich so ergebende Regelschleife sorgt für eine besonders genaue Einstellung des Stroms durch den Verbraucher.

Eine erfindungsgemäße Schaltung beinhaltet einen zuvor beschriebenen Konverter und ein LED-Modul. Eine besonders genaue Ansteuerung des LED-Moduls wird so erreicht.

Ein erfindungsgemäßes Verfahren dient dem Erfassen eines Wechselstroms. Das Verfahren beinhaltet ein Auskoppeln eines proportionalen Teils des Wechselstroms als Messstrom, ein Einspeisen eines Schaltsignals, ein von dem Schaltsignal gesteuertes Gleichrichten des Messstroms, ein Ausgeben eines gleichgerichteten Messstroms und ein durch das Schaltsignal gesteuertes Einschalten und Ausschalten des Gleichrichtens. Dadurch wird eine besonders genaue Erfassung des Messstroms erreicht.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes Ausführungsbeispiel der erfindungsgemäßen Schaltung, ein erstes Ausführungsbeispiel des erfindungsgemäßen Konverters und ein erstes Ausführungsbeispiel des erfindungsgemäßen Stromsensors in einem Blockschaltbild;
- Fig. 2: zeigt ein zweites Ausführungsbeispiel des erfindungsgemäßen Stromsensors in einem detaillierten Blockschaltbild;
- Fig. 3: zeigt ein zweites Ausführungsbeispiel der erfindungsgemäßen Schaltung, ein zweites Ausführungsbeispiel des erfindungsgemäßen Konverters und ein drittes Ausführungsbeispiel des erfindungsgemäßen Stromsensors in einem Schaltplan;
- Fig. 4: zeigt ein viertes Ausführungsbeispiel des erfindungsgemäßen Stromsensors in einem detaillierten Schaltplan;
- Fig. 5: zeigt Spannungsverläufe und Stromverläufe in einem exemplarischen Konverter, bei welchem keine erfindungsgemäße gesteuerte Gleichrichtung stattfindet;
- Fig. 6: zeigt exemplarische Spannungsverläufe und Stromverläufe in einem dritten Ausführungsbeispiel des erfindungsgemäßen Konverters, bei welchem eine erfindungsgemäße gesteuerte Gleichrichtung stattfindet, und
- Fig. 7: zeigt ein Ausführungsbeispiel des erfindungsgemäßen Verfahrens in einem Flussdiagramm.

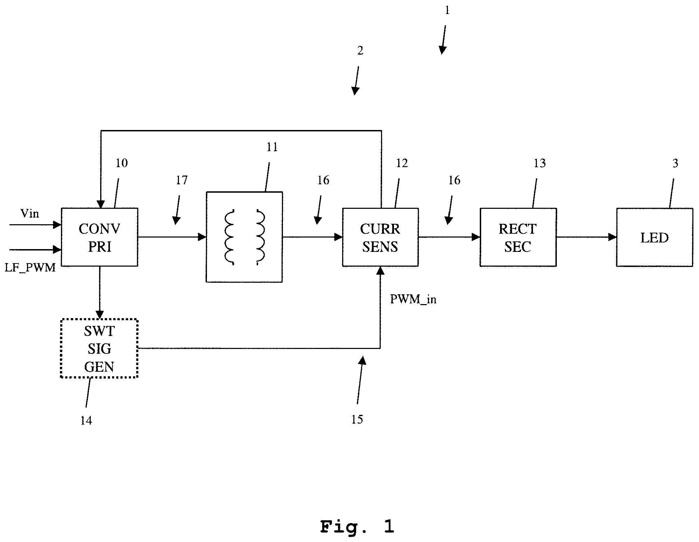

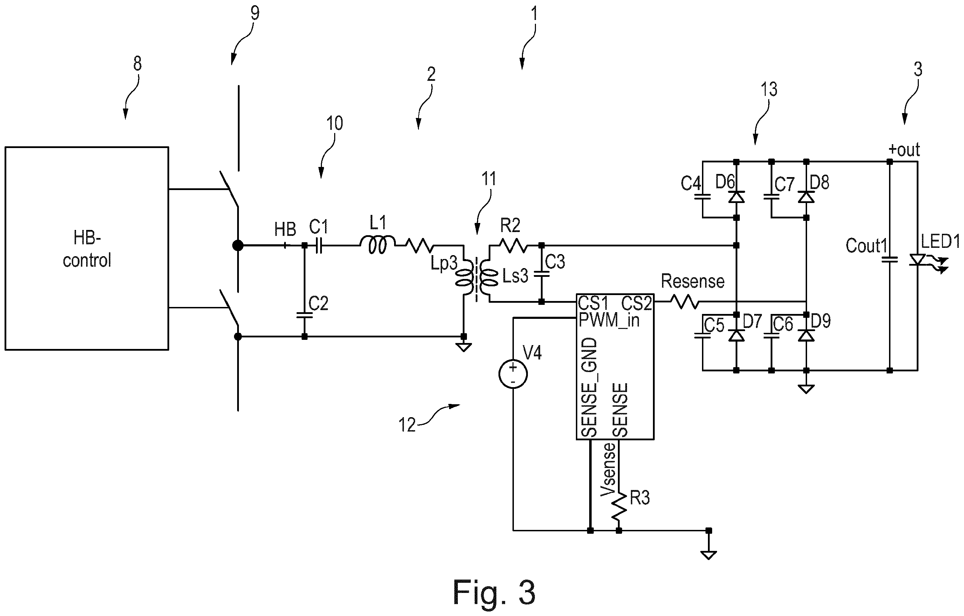

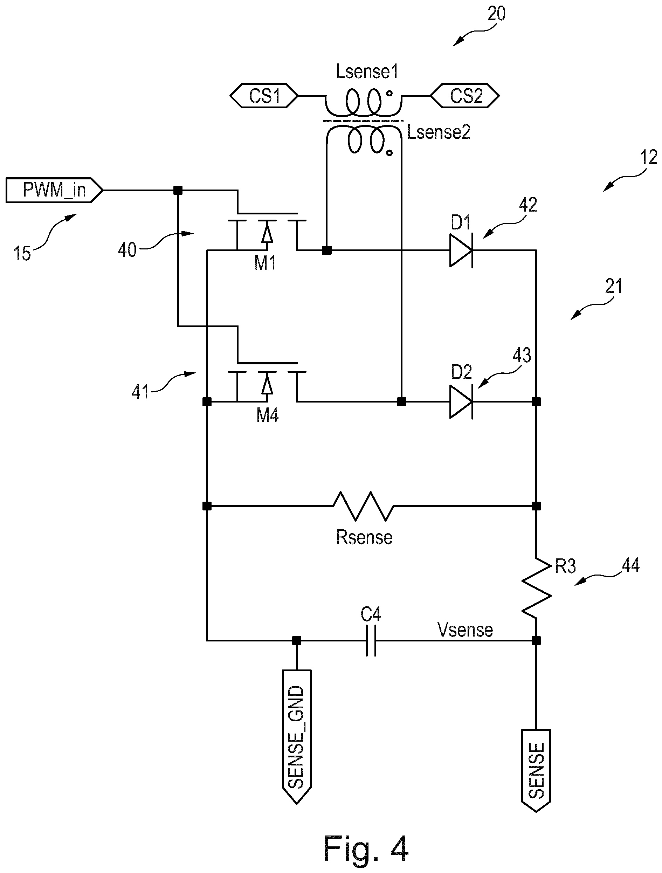

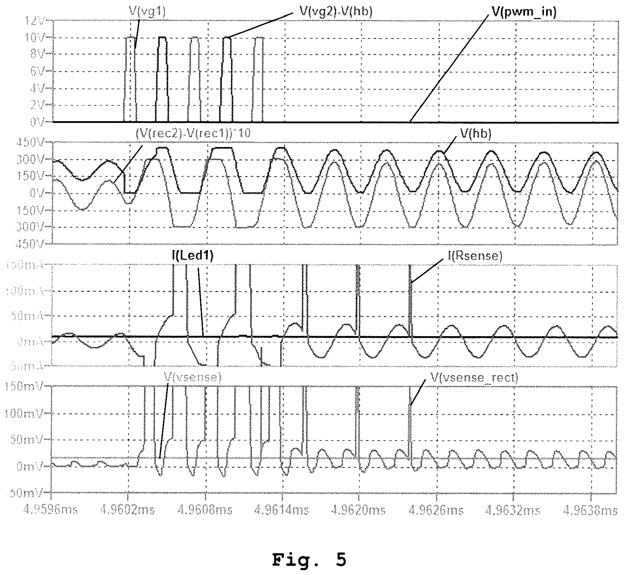

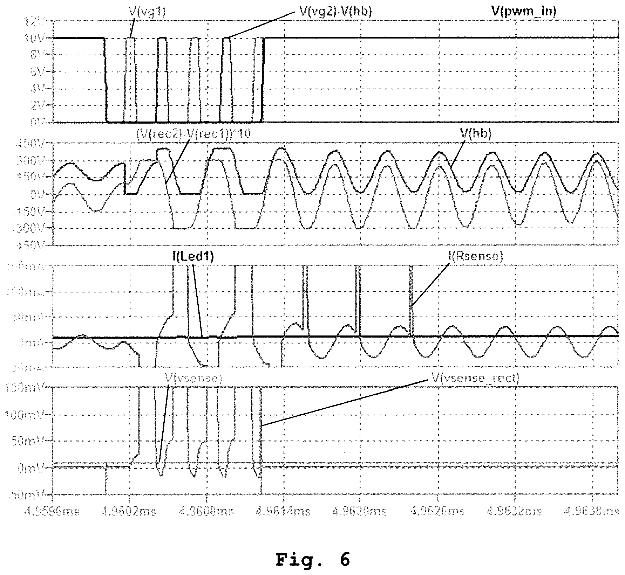

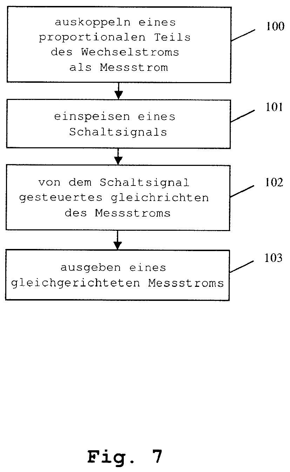

Zunächst wird anhand der Fig. 1 - 2 die generelle Funktionsweise verschiedener Ausführungsbeispiele der erfindungsgemäßen Vorrichtungen dargestellt. Anhand von Fig. 3 und Fig. 4 wird auf weitere Details des Aufbaus und der Funktionsweise eingegangen. Anhand von Fig. 5 und Fig. 6 wird die Funktionsweise weiter verdeutlicht. Letztlich wird anhand von Fig. 7 die Funktionsweise eines Ausführungsbeispiels des erfindungsgemäßen Verfahrens veranschaulicht. Identische Elemente wurden in ähnlichen Abbildungen zum Detail nicht wiederholt dargestellt und beschrieben.

In Fig. 1 ist ein erstes Ausführungsbeispiel der erfindungsgemäßen Schaltung 1 dargestellt. Die Schaltung 1 beinhaltet einen erfindungsgemäßen Konverter 2. Der Konverter 2 beinhaltet eine primärseitige Konverter-Einrichtung 10 verbunden mit einem Koppler 11, welcher durch einen Stromsensor 12 mit einer sekundärseitigen Gleichrichter-Einrichtung 13 verbunden ist. Die sekundärseitige Gleichrichter-Einrichtung 13 des Konverters 2 ist mit einem LED-Modul 3 der Schaltung 1 verbunden.

Vorzugsweise beinhaltet der Konverter 2 weiterhin einen Schaltsignalgenerator 14, welcher verbunden ist mit der primärseitigen Konverter-Einrichtung 10 und dem Stromsensor 12.

Im Betrieb wird die primärseitige Konverter-Einrichtung 10 mit einer Eingangsspannung Vᵢₙ und einem Dimmsignal LF_PWM versorgt. Die Eingangsspannung ist dabei eine Gleichspannung. Die primärseitige Konverter-Einrichtung 10 erzeugt dabei aus der Eingangsspannung Vᵢₙ einen primärseitigen Wechselstrom 17, welcher dem Koppler 11 zugeführt wird. Basierend auf dem Dimmsignal LF_PWM erfolgt dabei eine Dimmung durch einen "Burst-Betrieb" der Halbbrücke. Insbesondere erfolgt dabei eine Helligkeitsänderung durch einen Puls-Pause-Betrieb (bspw. im kHz Bereich, z.B. bei 50 kHz, der DC-DC-Konverter selbst kann dann im MHz Bereich arbeiten wie bspw. 2 oder 4 MHz).

Der Koppler 11 erzeugt hieraus einen sekundärseitigen Wechselstrom 16, welcher durch den Stromsensor 12 fließt und der sekundärseitigen Gleichrichter-Einrichtung 13 zugeführt wird. Die sekundärseitige Gleichrichter-Einrichtung 13 erzeugt hieraus einen Betriebsstrom für das LED-Modul 3.

Die primärseitige Konverter-Einrichtung 10 arbeitet dabei vorzugsweise als Halbbrücke, d.h. durch hochfrequentes Schalten eines Schalters wird aus der Eingangsspannung Vᵢₙ die angestrebte Ausgangsspannung erzeugt, welche den primärseitigen Wechselstrom treibt. Das pulsweitenmodulierte Signal wird am Ausgang des Gleichspannungswandlers wieder geglättet.

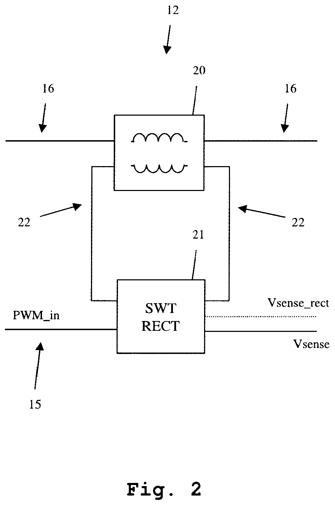

Wie zuvor beschrieben, kann es während den Ausschaltzeiten dieser Halbbrücke zu Fehlmessungen eines herkömmlichen Stromsensors, welcher dauerhaft misst, kommen. Insbesondere wenn während der Aus-Phase der Halbbrücke die Strommessung erfolgt, treten diese Fehlerströme auf. Der erfindungsgemäße Stromsensor 12 ist somit derart ausgebildet, dass dieser basierend auf einem Schaltsignal 15 arbeitet. Dadurch erfasst der Stromsensor während der Ausschaltzeiten der Halbbrücke keine Fehlerströme. Darauf wird näher anhand von Fig. 2 und 4 eingegangen.

Das Schaltsignal 15 wird dabei entweder direkt von der primärseitigen Konverter-Einrichtung 10 erzeugt, und dem Stromsensor 12 zugeführt, oder ein optionaler Schaltsignal-Generator 14 wird zur Erzeugung des Schaltsignals genutzt. Der Schaltsignal-Generator 14 empfängt in diesem Fall von der primärseitigen Konverter-Einrichtung 10 ein Signal, welches die Schaltzeiten der Halbbrücke widerspiegelt, und erzeugt daraus das Schaltsignal 15 des Stromsensors 12.

Vorzugsweise besteht eine Rückkopplung zwischen dem Stromsensor 12 und der primärseitigen Konverter-Einrichtung 10, d.h. basierend auf dem von dem Stromsensor 12 gemessenen Strom erfolgt eine Anpassung der Schaltvorgänge der primärseitigen Konverter-Einrichtung 10. Durch diese Rückkoppelschleife oder auch Regelschleife wird eine besonders genaue Einstellung des Verbraucherstroms erreicht.

In Fig. 2 ist ein detailliertes Blockdiagramm des Stromsensors 12 dargestellt. Der Stromsensor 12 beinhaltet dabei einen Koppler 20, verbunden mit einem schaltbaren Gleichrichter 21. Eine Primärseite des Kopplers 20 ist mit der Sekundärseite des Kopplers 11 und der sekundärseitigen Gleichrichter-Einrichtung 13 aus Fig. 1 verbunden. Die Sekundärseite des Kopplers 20 ist mit dem schaltbaren Gleichrichter 21 verbunden. Der schaltbare Gleichrichter 21 beinhaltet dabei einen Schaltanschluss, welcher zur Einspeisung des Schaltsignals 15 ausgebildet ist. Darüber hinaus gibt der schaltbare Gleichrichter das Ausgangssignal Vsense aus. Vsense ist dabei eine Spannung, welche einem durchschnittlichen gleichgerichteten Messstrom entspricht, während Vsens_rect ist eine Spannung ist, welche proportional zu dem gleichgerichteten Messstrom ist. Optional kann zusätzlich Vsens_rect ausgegeben werden.

Der sekundärseitige Wechselstrom 16 fließt dabei durch die Primärseite des Kopplers 20. Ein proportionaler sehr kleiner Anteil des Wechselstroms 16 wird als Wechselstrom 22 des Kopplers 20 ausgekoppelt und dem schaltbaren Gleichrichter 21 zugeführt. Der schaltbare Gleichrichter 21 führt eine Gleichrichtung durch, solange das Schaltsignal 15 dies vorgibt. Solange das Schaltsignal 15 dies nicht vorgibt, führt der schaltbare Gleichrichter 21 keine Gleichrichtung durch, sondern schließt den Wechselstrom 22 kurz.

Das Schaltsignal 15 basiert wie zuvor beschrieben auf dem Schaltverhalten der primärseitigen Konverter-Einrichtung 10 aus Fig. 1. Insbesondere entspricht das Schaltsignal 15 einem Inversen des Schaltverhaltens der Halbbrücke der primärseitigen Konverter-Einrichtung 10.

D.h. während der Ausschaltphasen der Halbbrücke weist das Schaltsignal 15 einen Ein-Zustand auf. Dieser Ein-Zustand deaktiviert den schaltbaren Gleichrichter 21 während der Ausschaltphase der Halbbrücke der primärseitigen Konverter-Einrichtung 10. Während den Einschaltphasen der Halbbrücke der primärseitigen Konverter-Einrichtung 10 weist das Schaltsignal 15 einen Aus-Zustand auf, dies führt dazu, dass der schaltbare Gleichrichter 21 den Messstrom 22 gleichrichtet und ein das dazu proportionale Signal Vsens_rect erzeugt. Der schaltbare Gleichrichter 21 weist darüber hinaus eine Glättungseinrichtung auf, welche aus dem Signal Vsens_rect ein Durchschnittssignal Vsense bildet.

In Fig. 3 ist ein konkretes Schaltbild einer erfindungsgemäßen Schaltung dargestellt. Die Schaltung 1 weist eine Halbbrücke 9, eine Halbbrückensteuerung 8, einen Konverter 2 und ein LED-Modul 3 auf. Der Konverter 2 weist dabei eine primärseitige Konverter-Einrichtung 10, einen Koppler 11, einen Stromsensor 12 und eine sekundärseitige Gleichrichter-Einrichtung 13 auf. Insbesondere ist das LED-Modul 3 mit der sekundärseitigen Gleichrichter-Einrichtung 13 verbunden. In Fig. 3 ist der erfindungsgemäße Stromsensor lediglich exemplarisch dargestellt.

Eine genaue Konstruktionsweise des Stromsensors 12 kann Fig. 4 entnommen werden. Die nicht erfindungswesentlichen Bauelemente wurden zum Teil nicht dargestellt und zum Teil nicht ausführlich beschrieben.

Der Stromsensor 12 beinhaltet dabei den zuvor beschriebenen Koppler 20, welcher zwischen die Sekundärseite des Kopplers 11 und die sekundärseitige Gleichrichter-Einrichtung 13 geschaltet ist. Die Sekundärseite des Kopplers 20 ist dabei mit dem schaltbaren Gleichrichter 21 verbunden. An einem ersten Knoten sind zwei Transistoren 40, 41 als aktive Schaltelemente eingangsseitig parallel geschaltet. An einem zweiten Knoten ist der Transistor 40 in Serie zu einer Diode 42 geschaltet und zusätzlich mit einem ersten Anschluss der Sekundärseite des Kopplers 20 verbunden. An einem dritten Knoten ist der Transistor 41 mit einer Diode 43 in Serie geschaltet, und zusätzlich mit dem zweiten Anschluss der Sekundärseite des Kopplers 20 verbunden. An einem vierten Knoten sind die Dioden 42, 43 ausgangsseitig parallel geschaltet.

Zwischen dem ersten Knoten und dem vierten Knoten wird dabei der gleichgerichtete Messstrom erzeugt, dieser fließt über einen Widerstand R_{SENSE} und erzeugt so die Spannung Vsens_rect. Diese Spannung kann optional zusätzlich ausgegeben werden.

Steueranschlüsse der Transistoren 40, 41 sind dabei mit dem Schaltsignal 15 versorgt. An dem vierten Knoten wird die Spannung Vsens_rect, welche proportional zu dem gleichgerichteten Messstrom ist, erzeugt.

Der Stromsensor 12 verfügt darüber hinaus über eine Glättungseinrichtung 44, welche aus einem Kondensator C4 und einem ohmschen Widerstand R3 besteht. Die Glättungseinrichtung führt dabei eine Glättung der Spannung Vsens_rect durch und erzeugt dadurch die Spannungssens, welche proportional zu einem durchschnittlichen gleichgerichteten Messstrom ist.

Da die Transistoren 40, 41 gesteuert durch das Schaltsignal 15 lediglich Strom leiten, während die Halbbrücke der primärseitigen Konverter-Einrichtung 10 eingeschaltet ist, erfolgt lediglich zu diesen Zeiten eine Gleichrichtung durch den schaltbaren Gleichrichter 21. Während die Halbbrücke ausgeschaltet ist, erfolgt keine Gleichrichtung durch einen schaltbaren Gleichrichter 21. Daraus folgt, dass zu diesen Zeiten das Signal Vsens_rect 0 ist, was sich durch eine Verringerung des Signals Vsense auswirkt.

In der hier dargestellten Ausführungsform werden beim Gleichrichter für die "low side" Gelichrichtelemente zwei aktive Schaltelemente, die Transistoren 40, 41 genutzt. Diese weisen hier jeweils eine bevorzugt integrierte Freilaufdiode 42, 43 auf. Wenn die beiden unteren Gleichrichtelemente angesteuert werden, kann dies ohne aufwendige "high side" Ansteuerung erfolgen. Alternativ ist jedoch ein Ausführungsbeispiel mit zwei zusätzlichen aktiven Bauelementen an Stelle der Freilaufdioden 42, 43 denkbar.

In Fig. 5 sind exemplarische Ströme und Spannungsverläufe ohne Nutzung des Schaltsignals 15, welches hier als Vpwm_in bezeichnet ist. Dies entspricht somit einem herkömmlichen Konverter.

Deutlich erkennbar sind in dem ersten Diagramm von oben dabei die Schaltimpulse der Halbbrücke während der Einschaltzeit der Halbbrücke als Signale V(vg1) und V(Vg2)-V(hb) .

Die Ausgangsspannung der Halbbrücke V(hb) sowie die sekundärseitige Ausgansspannung Vrec2-Vrec1 sind in dem zweiten Diagramm von oben dargestellt.

In dem dritten Diagramm von oben sind ein Verbraucherstrom I(Led1) und ein von einem Stromsensor erfasster Strom I(Rsense) dargestellt. Deutlich wird hier, dass während der Schaltzeiten der Halbbrücke wie auch während der Ausschaltzeit der Halbbrücke durch den Stromsensor ein Strom erfasst wird, obwohl während der Ausschaltzeit der Halbbrücke lediglich Fehlerströme anliegen.

In dem untersten Diagramm werden die entsprechenden Verläufe der Spannungen Vsense_rect und Vsense dargestellt. Deutlich erkennbar ist, dass die Fehlerströme während der Ausschaltzeit der Halbbrücke zu gemessenen Impulsen führen, was die Messung verfälscht.

In Fig. 6 sind dieselben Signale wie in Fig. 5, jedoch unter Nutzung eines geschalteten Gleichrichters innerhalb des Stromsensors, dargestellt. Deutlich erkennbar ist nun im ersten Diagramm von oben, das das Steuersignal Vpwm_in während der Ausschaltzeit der Halbbrücke einen hohen Pegel hat, was einem Ein-Zustand entspricht. Dies führt dazu, dass das Signal Vsense_rect den Messstrom während dieser Ausschaltzeit nicht widerspiegelt, da dieser zu dieser Zeit lediglich aus Fehlerstrom besteht. Ein deutlich niedriger Wert Vsense ergibt sich hierdurch gegenüber dem Fehlerstrom behafteten Wert aus Fig. 5.

Zuletzt ist in Fig. 7 ein Ausführungsbeispiel des erfindungsgemäßen Verfahrens in einem Flussdiagramm dargestellt. In einem ersten Schritt 100 wird ein proportionaler Teil des Wechselstroms als Wechselstrom ausgekoppelt, in einem zweiten Schritt 101 wird ein Schaltsignal eingespeist. In einem dritten Schritt 102 erfolgt ein von dem Schaltsignal gesteuertes Gleichrichten des Messstroms. In einem vierten Schritt 103 wird ein gleichgerichteter Messstrom ausgegeben.

Es ist dabei wichtig zu erwähnen, dass das erfindungsgemäße Verfahren und die erfindungsgemäße Vorrichtung einander sehr eng entsprechen und somit die Ausführungen zu der Erfindung gemäßen Vorrichtung jedenfalls für das erfindungsgemäße Verfahren gültig sind.

Die erfindungsgemäße Vorrichtung und das erfindungsgemäße Verfahren ermöglichen eine sehr genaue Messung im gesamten Dimmbereich. Diodenkapazitäten verfälschen die Messung nicht länger. Dies ermöglicht eine besonders große Freiheit bei der Komponentenauswahl. Diese Stromerfassung kann bei fremdgesteuerten und selbstschwingenden Halbbrücken mit Pulsweiten-Modulationsbetrieb eingesetzt werden.

Die Erfindung ist nicht auf das dargestellte Ausführungsbeispiel beschränkt. Alle vorstehenden beschriebenen Merkmale oder in den Figuren gezeigte Merkmale sind im Rahmen der Erfindung beliebig vorteilhaft miteinander kombinierbar.

## Patentansprüche

1. Stromsensor (12), zur Erfassung eines Wechselstroms (16), aufweisend:
- einen Koppler (20), welcher ausgebildet ist, um einen proportionalen Teil des Wechselstroms (16) als Messstrom (22) auszukoppeln,
- einen Schaltanschluss, welcher zur Einspeisung eines Schaltsignals (15) ausgebildet ist, und
- einen schaltbaren Gleichrichter (21), welcher ausgebildet ist, um den Messstrom (22) gesteuert von dem Schaltsignal (15), gleichzurichten, und als gleichgerichteten Messstrom (Vsense) auszugeben, wobei der schaltbare Gleichrichter (21) eine Schalteinrichtung (40, 41) beinhaltet,
**dadurch gekennzeichnet, dass** die Schalteinrichtung (40, 41) ausgebildet ist, um gesteuert durch das Schaltsignal (15) die Gleichrichtung durch den schaltbaren Gleichrichter (21) einzuschalten und auszuschalten.

2. Stromsensor (12) nach Anspruch 1,
wobei die Schalteinrichtung (40, 41) zumindest zwei Transistoren (40, 41) aufweist, welche ausgebildet sind, um gesteuert durch das Schaltsignal (15) die Gleichrichtung durch den schaltbaren Gleichrichter (21) einzuschalten und auszuschalten.

3. Stromsensor (12) nach Anspruch 1,
wobei der schaltbare Gleichrichter (21) einen ersten Transistor (40), eine erste Diode (42), einen zweiten Transistor (41), und eine zweite Diode (43) aufweist, wobei an einem ersten Knoten der erste Transistor (40) und der zweite Transistor (41) eingangsseitig parallel geschaltet sind,
wobei an einem zweiten Knoten die erste Diode (42) in Serie zu dem ersten Transistor (40) geschaltet ist,
wobei an einem dritten Knoten die zweite Diode (43) in Serie zu dem zweiten Transistor (41) geschaltet ist, und wobei an einem vierten Knoten die erste Diode (42) und die zweite Diode (43) ausgangsseitig parallel geschaltet sind.

4. Stromsensor (12) nach Anspruch 3,
wobei der schaltbare Gleichrichter (21) ausgebildet ist, um den Messstrom (22) an dem zweiten Knoten und dem dritten Knoten zu empfangen, und
dass der schaltbare Gleichrichter (21) ausgebildet ist, um den gleichgerichteten Messstrom (Vsense) an dem ersten Knoten und dem vierten Knoten auszugeben.

5. Konverter (2), aufweisend:
- eine primärseitigen Konverter-Einrichtung (10),
- einen Koppler (11),
- eine sekundärseitige Gleichrichter-Einrichtung (13), und
- einen Stromsensor (12) nach einem der Ansprüche 1 bis 4.

6. Konverter (2) nach Anspruch 5,
wobei das Schaltsignal (15) auf Schaltzeiten der primärseitigen Konverter-Einrichtung (10) basiert.

7. Konverter (2) nach Anspruch 6, aufweisend:
einen Schaltsignal-Generator (14), welcher ausgebildet ist, um das Schaltsignal (15) basierend auf Schaltzeiten der primärseitigen Konverter-Einrichtung (10) zu erzeugen.

8. Konverter (2) nach Anspruch 7,
wobei der Schaltsignal-Generator (14) ausgebildet ist, um das Schaltsignal (15) als Inverses der Schaltvorgänge einer Halbbrücke der primärseitigen Konverter-Einrichtung (10) zu erzeugen.

9. Konverter (2) nach Anspruch 8,
wobei der schaltbare Gleichrichter (21) ausgebildet ist, um
- den Messstrom (22) während einer Einschaltphase der Halbbrücke der primärseitigen Konverter-Einrichtung (10) gleichzurichten, und
- den Messstrom (22) während einer Ausschaltphase der Halbbrücke der primärseitigen Konverter-Einrichtung (10) nicht gleichzurichten.

10. Konverter (2) nach einem der Ansprüche 5 bis 9, wobei die primärseitigen Konverter-Einrichtung (10) ausgebildet ist, um basierend auf dem gleichgerichteten Messstrom (Vsense) zu arbeiten.

11. Schaltung (1) mit einem Konverter (2) nach einem der Ansprüche 5 bis 10, und einem LED-Modul (3).

12. Verfahren zum Erfassen eines Wechselstroms (16), aufweisend:
- Auskoppeln (100) eines proportionalen Teils des Wechselstroms (16) als Messstrom (22),
- Einspeisen (101) eines Schaltsignals (15),
- von dem Schaltsignal (15) gesteuertes Gleichrichten (102) des Messstroms (22), und
- Ausgeben (103) eines gleichgerichteten Messstroms (Vsense),
**gekennzeichnet durch** ein durch das Schaltsignal (15) gesteuertes Einschalten und Ausschalten des Gleichrichtens (102).

## Claims

1. Current sensor (12) for detecting an alternating current (16), comprising:
- a coupler (20) designed to couple out a proportional part of the alternating current (16) as a measurement current (22),
- a switching terminal designed to feed in a switching signal (15), and
- a switchable rectifier (21) designed to rectify the measurement current (22) in a manner controlled by the switching signal (15) and to output it as a rectified measurement current (Vsense), wherein the switchable rectifier (21) contains a switching device (40, 41),
**characterized in that** the switching device (40, 41) is designed to switch on and switch off the rectification by the switchable rectifier (21) in a manner controlled by the switching signal (15).

2. Current sensor (12) according to claim 1, wherein the switching device (40, 41) comprises at least two transistors (40, 41) designed to switch on and switch off the rectification by the switchable rectifier (21) in a manner controlled by the switching signal (15).

3. Current sensor (12) according to claim 1, wherein the switchable rectifier (21) has a first transistor (40), a first diode (42), a second transistor (41), and a second diode (43), wherein, at a first node, the first transistor (40) and the second transistor (41) are connected in parallel on the input side,
wherein, at a second node, the first diode (42) is connected in series to the first transistor (40), wherein, at a third node, the second diode (43) is connected in series to the second transistor (41), and wherein, at a fourth node, the first diode (42) and the second diode (43) are connected in parallel on the output side.

4. Current sensor (12) according to claim 3,
wherein the switchable rectifier (21) is designed to receive the measurement current (22) at the second node and the third node, and
that the switchable rectifier (21) is designed to output the rectified measurement current (Vsense) at the first node and the fourth node.

5. Converter (2) comprising:
- a primary-side converter device (10),
- a coupler (11),
- a secondary-side rectifier device (13), and
- a current sensor (12) according to any of claims 1 to 4.

6. Converter (2) according to claim 5, wherein the switching signal (15) is based on switching times of the primary-side converter device (10).

7. Converter (2) according to claim 6, comprising: a switching signal generator (14) designed to generate the switching signal (15) on the basis of switching times of the primary-side converter device (10).

8. Converter (2) according to claim 7, wherein the switching signal generator (14) is designed to generate the switching signal (15) as inverses of the switching processes of a half-bridge of the primary-side converter device (10).

9. Converter (2) according to claim 8, wherein the switchable rectifier (21) is designed
- to rectify the measurement current (22) during a switch-on phase of the half-bridge of the primary-side converter device (10), and
- not to rectify the measurement current (22) during a switch-off phase of the half-bridge of the primary-side converter device (10).

10. Converter (2) according to any of claims 5 to 9, wherein the primary-side converter device (10) is designed to operate on the basis of the rectified measurement current (Vsense).

11. Circuit (1) comprising a converter (2), according to any of claims 5 to 10, and an LED module (3).

12. Method for detecting an alternating current (16), comprising:
- coupling-out (100) a proportional part of the alternating current (16) as a measurement current (22),
- feeding-in (101) a switching signal (15),
- rectification (102) of the measurement current (22) in a manner controlled by the switching signal (15), and
- outputting (103) a rectified measurement current (Vsense),
**characterized by** switching on and switching off the rectification (102) in a manner controlled by the switching signal (15).

## Revendications

1. Capteur de courant (12), destiné à détecter un courant alternatif (16), présentant :
- un coupleur (20), lequel est configuré pour découpler une partie proportionnelle du courant alternatif (16) en tant que courant de mesure (22),
- une borne de commutation, laquelle est configurée pour injecter un signal de commutation (15), et
- un redresseur commutable (21), lequel est configuré pour redresser le courant de mesure (22) de manière régulée par le signal de commutation (15) et pour l'émettre en sortie en tant que courant de mesure redressé (Vsense), le redresseur commutable (21) comprenant un dispositif de commutation (40, 41),
**caractérisé en ce que** le dispositif de commutation (40, 41) est configuré pour activer et pour désactiver le redressement par le redresseur commutable (21) de manière régulée par le signal de commutation (15).

2. Capteur de courant (12) selon la revendication 1, le dispositif de commutation (40, 41) présentant au moins deux transistors (40, 41) qui sont configurés pour activer et pour désactiver le redressement par le redresseur commutable (21) de manière régulée par le signal de commutation (15).

3. Capteur de courant (12) selon la revendication 1, le redresseur commutable (21) présentant un premier transistor (40), une première diode (42), un second transistor (41) et une seconde diode (43), le premier transistor (40) et le second transistor (41) étant commutés en parallèle côté entrée au niveau d'un premier noeud,
la première diode (42) étant commutée en série par rapport au premier transistor (40) au niveau d'un deuxième noeud, la seconde diode (43) étant commutée en série par rapport au second transistor (41) au niveau d'un troisième noeud, et la première diode (42) et la seconde diode (43) étant commutées en parallèle côté sortie au niveau d'un quatrième noeud.

4. Capteur de courant (12) selon la revendication 3,
le redresseur commutable (21) étant configuré pour recevoir le courant de mesure (22) au niveau du deuxième noeud et du troisième noeud, et
en ce que le redresseur commutable (21) est configuré pour émettre en sortie le courant de mesure redressé (Vsense) au niveau du premier noeud et du quatrième noeud.

5. Convertisseur (2), présentant :
- un dispositif convertisseur côté primaire (10),
- un coupleur (11),
- un dispositif redresseur côté secondaire (13), et
- un capteur de courant (12) selon l'une des revendications 1 à 4.

6. Convertisseur (2) selon la revendication 5, le signal de commutation (15) étant basé sur des temps de commutation du dispositif convertisseur côté primaire (10).

7. Convertisseur (2) selon la revendication 6, présentant : un générateur de signal de commutation (14), lequel est configuré pour générer le signal de commutation (15) sur la base de temps de commutation du dispositif convertisseur côté primaire (10).

8. Convertisseur (2) selon la revendication 7, le générateur de signal de commutation (14) étant configuré pour générer le signal de commutation (15) en tant qu'inverse des processus de commutation d'un demi-pont du dispositif convertisseur côté primaire (10).

9. Convertisseur (2) selon la revendication 8, le redresseur commutable (21) étant configuré pour
- redresser le courant de mesure (22) pendant une phase d'activation du demi-pont du dispositif convertisseur côté primaire (10), et
- ne pas redresser le courant de mesure (22) pendant une phase de désactivation du demi-pont du dispositif convertisseur côté primaire (10).

10. Convertisseur (2) selon l'une des revendications 5 à 9, le dispositif convertisseur côté primaire (10) étant configuré pour travailler sur la base du courant de mesure redressé (Vsense).

11. Circuit (1) comportant un convertisseur (2) selon l'une des revendications 5 à 10 et un module à DEL (3).

12. Procédé destiné à détecter un courant alternatif (16), présentant :
- le découplage (100) d'une partie proportionnelle du courant alternatif (16) en tant que courant de mesure (22),
- l'injection (101) d'un signal de commutation (15),
- le redressement (102), régulé par le signal de commutation (15), du courant de mesure (22), et
- l'émission en sortie (103) d'un courant de mesure redressé (Vsense),
**caractérisé par** une activation et une désactivation du redressement (102) régulées par le signal de commutation (15).
